# EUROPEAN PATENT SPECIFICATION

(11) **EP 3 061 793 B1**
(45) Date of publication and mention of the grant of the patent: **15.04.2020**
(21) Application number: 14856120.2
(22) Date of filing: 20.10.2014
(51) Int. Cl.: C08L 101/12, C08L 39/06, C08L 79/00, C09D 139/04, C09D 165/02, C09D 201/00, H01B 1/12, H01B 1/20, H01B 5/14, H01B 13/00

(54) **ELECTRICALLY CONDUCTIVE COMPOSITION, ELECTRICAL CONDUCTOR, ELECTRICAL CONDUCTOR FORMATION METHOD, AND PRODUCTION METHOD FOR POLYMER**
ELEKTRISCH LEITFÄHIGE ZUSAMMENSETZUNG, ELEKTRISCHER LEITER, HERSTELLUNGSVERFAHREN FÜR DEN ELEKTRISCHEN LEITER UND HERSTELLUNGSVERFAHREN FÜR EIN POLYMER
COMPOSITION ÉLECTROCONDUCTRICE, CONDUCTEUR ÉLECTRIQUE, PROCÉDÉ DE FORMATION DE CONDUCTEUR ÉLECTRIQUE, ET PROCÉDÉ DE PRODUCTION DE POLYMÈRE

(30) Priority: 21.10.2013 JP 2013218260
(43) Date of publication of application: 31.08.2016
(73) Proprietor: Mitsubishi Chemical Corporation, Tokyo 100-8251 (JP)
(72) Inventor: FUKUDA Hiroya, Toyohashi-shi, Aichi 440-8601 (JP); UZAWA Masashi, Toyohashi-shi, Aichi 440-8601 (JP)
(74) Representative: TBK
(86) International application number: PCT/JP2014/077794
(87) International publication number: WO 2015/060231

(56) References cited:
- EP-A1- 1 854 844
- WO-A1-2012/043025
- WO-A1-2014/017540
- JP-A- S5 778 407
- JP-A- H11 185 523
- JP-A- 2001 115 098
- JP-A- 2002 226 721

## Description

### Field of the Invention

The present invention relates to a conductive composition, conductor, method for forming a conductor and method for producing a polymer.

### Background Art

Pattern formation technology using charged-particle beams such as electron beams and ion beams is anticipated to be the next-generation technology for photolithography. When charged-particle beams are used, enhanced sensitivity of the resist is important for improving productivity.

Accordingly, current mainstream methods use highly sensitive chemically amplified resists, where acid is generated in portions exposed to light or irradiated by charged-particle beams and a process of crosslinking reactions or decomposing reactions is accelerated by post exposure bake (PEB).

In a method using charged-particle beams, especially in a method that entails a substrate made of insulating material, it is hard to obtain desired patterns because the orbits of charged-particle beams are bent due to the electric field generated when a charge-up of the substrate occurs.

To solve the above-mentioned problem, an effective technology known to date is to form a film on a resist surface by coating a conductive composition that contains a conductive polymer so as to provide an antistatic property for the resist.

When a conductive composition containing a conductive polymer is used as an antistatic agent during electron-beam lithography in the production process of semiconductors, the coating properties of the conductive composition is typically in a trade-off relationship with the impact of the composition exerted on a substrate and on a laminate layer such as a resist coated on the substrate.

For example, when an additive such as a surfactant is added to a conductive composition to enhance its coating properties, the surfactant may adversely affect the resist characteristics and cause problems such as failed formation of desired patterns.

To solve such problems, as an example of a conductive composition with excellent coating properties, Patent Literature 1 proposes a conductive composition containing a water-soluble polymer with a terminal hydrophobic group having 12 carbon atoms.

### PRIOR ART LITERATURE

### PATENT LITERATURE

Patent Literature 1: JP2002-226721A

### SUMMARY OF THE INVENTION

### PROBLEMS TO BE SOLVED BY THE INVENTION

However, it is difficult to apply a conductor containing the conductive composition described in Patent Literature 1 to the next-generation process for manufacturing semiconductor devices. For example, when semiconductor devices are used for a long duration under high temperatures of 100°C or higher, the laminated layer such as a resist coated on a substrate may corrode, thereby resulting in a reduction in film thickness.

The present invention was carried out to solve the above-mentioned problems. Its objective is to provide a conductive composition that exhibits excellent coating properties and conductivity, and is capable of forming a film that is less likely to exert adverse impacts (reduction in film thickness, hardened film, degradation of patterns, etc.) on a laminated layer such as a resist coated on a substrate, as well as to provide a conductor that includes a film formed by coating the conductive composition on a substrate.

### SOLUTIONS TO THE PROBLEMS

As a result of extensive studies to solve the above problems, the inventors of the present invention have found that when the number of carbon atoms of a terminal hydrophobic group is set at 13 or greater in a water-soluble polymer containing the terminal hydrophobic group, the coating properties of the composition is maintained and a film is formed to have less impact on the laminated layer such as a resist coated on a substrate.

Namely, the present invention is characterized by the following.
[1] A conductive composition containing a conductive material (A), and a water-soluble polymer (b) containing a hydrophilic group and a terminal hydrophobic group having at least 13 carbon atoms, wherein the conductive material (A) is a conductive polymer (a), wherein the hydrophilic group of the water-soluble polymer (b) contains a nitrogen atom and wherein the conductive polymer (a) contains a sulfonic acid group or carboxylic acid group.
[2] The conductive composition described in [1], in which the conductive material (A) is a water-soluble polymer (other than polymer (b)).
[3] The conductive composition described in [1] or [2], in which the hydrophilic group of the water-soluble polymer (b) is an amide group.
[4] The conductive composition described in any of [1]∼[3], in which the terminal hydrophobic group of the water-soluble polymer (b) contains at least a chain selected from among alkyl chains, aralkyl chains and aryl chains.
[5] The conductive composition described in [4], in which the terminal hydrophobic group of the water-soluble polymer (b) contains at least a group selected from among alkylthio groups, aralkylthio groups and arylthio groups.
[6] The conductive composition described in any of [1]∼[5], in which the water-soluble polymer (b) contains a hydrophilic group and a terminal hydrophobic group having at least 16 carbon atoms.
[7] The conductive composition described in any of [1]∼[6], in which the mass average molecular weight of the water-soluble polymer (b) is 1500 or greater.
[8] The conductive composition described in any of [1]∼[7], in which the content of the water-soluble polymer (b) is 0.01∼50 mass% of the total mass (100 mass%) of the conductive composition.
[9] The conductive composition described in any of [1]∼[8], in which the conductive polymer (a) includes a repeating unit represented by general formula (1) below. 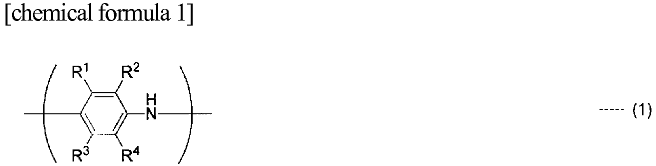 (In formula (1), R¹∼R⁴ independently represent a hydrogen atom, straight- or branched-chain alkyl group having 1∼24 carbon atoms, straight- or branched-chain alkoxy group having 1∼24 carbon atoms, acidic group, hydroxyl group, nitro group, or halogen atom (-F, -Cl, -Br or I); at least one of R¹∼R⁴ is an acidic group or its salt; and the acidic group is a sulfonic acid group or carboxylic acid group.)
[10] The conductive composition described in any of [1]∼[9], in which the water-soluble polymer (b) is represented by general formula (6) below. 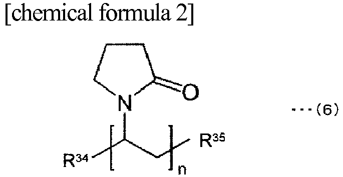 (In formula (6), at least either R³⁴ or R³⁵ is an alkylthio group, aralkylthio group or arylthio group; and "n" indicates an integer of 10∼100000.)
[11] A method for forming a conductor that has a chemically amplified resist layer formed on at least one surface of a substrate and a film formed on the chemically amplified resist layer by coating the conductive composition described in any of [1]∼[10].
[12] The method for forming a conductor described in [11], which includes forming a conductive-polymer film by coating the conductive composition described in any of [1]∼[10] on at least one surface of a substrate, and then leaving the film at room temperature or applying heat to the film.
[13] The method for forming a conductor described in [12], in which the temperature for applying heat is in a range of 40∼250°C.
[14] A conductor having a chemically amplified resist layer formed on at least one surface of a substrate and a layer formed by using the composition described in any of [1]∼[10] on the chemically amplified resist layer.
[15] A mask blank having a chemically amplified resist layer formed on at least one surface of a substrate and a layer formed on the chemically amplified resist layer by using the composition described in any of [1]∼[10].
[16] A method for forming a resist pattern by using the mask blank described in [15].
[17] The conductive composition described in [1]∼[10], in which the water-soluble polymer (b) has a mass average molecular weight of 1500 or greater and a surface tension of 10∼60 mN/m.
[18] A method for producing the water-soluble polymer (b) described in [17], in which a vinyl monomer having a hydrophilic group is polymerized in the presence of a polymerization initiator and a chain-transfer agent having at least 13 carbon atoms so as to produce a polymer having a hydrophilic group and a terminal hydrophobic group having at least 13 carbon atoms.

Namely, the present invention relates to the following.
[1'] A conductive composition containing conductive material (A) and a water-soluble polymer (b) containing a hydrophilic group and a terminal hydrophobic group having at least 13 carbon atoms, wherein the conductive material (A) contains a conductive polymer (a), wherein the hydrophilic group of the water-soluble polymer (b) contains a nitrogen atom and wherein the conductive polymer (a) contains a sulfonic acid group or carboxy group.
[2'] The conductive composition described in [1'], in which the conductive material (A) contains a water-soluble polymer.
[3'] The conductive composition described in [1'] or [2'], in which the hydrophilic group of the water-soluble polymer (b) is an amide group.
[4'] The conductive composition described in any of [1']∼[3'], in which the terminal hydrophobic group of the water-soluble polymer (b) is at least a group selected from among alkyl groups, aralkyl groups and aryl groups.
[5'] The conductive composition described in [4'], in which the terminal hydrophobic group of the water-soluble polymer (b) is at least a group selected from among alkylthio groups, aralkylthio groups and arylthio groups.
[6'] The conductive composition described in any of [1']∼[5'], in which the water-soluble polymer (b) contains a hydrophilic group and a terminal hydrophobic group having at least 16 carbon atoms.
[7'] The conductive composition described in any of [1']∼[6'], in which the mass average molecular weight of the water-soluble polymer (b) is 1500 or greater.
[8'] The conductive composition described in any of [1']∼[7'], in which the content of the water-soluble polymer (b) is 0.01∼50 mass% of the total mass of the conductive composition.
[9'] The conductive composition described in any of [1']∼[8'], in which the conductive polymer (a) includes a repeating unit represented by general formula (1) below. 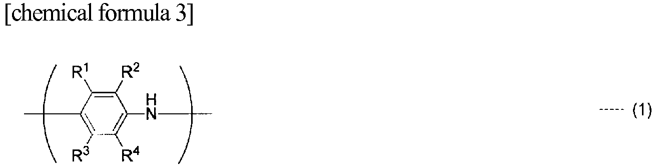 (In formula (1), R¹∼R⁴ independently represent a hydrogen atom, straight- or branched-chain alkyl group having 1∼24 carbon atoms, straight- or branched-chain alkoxy group having 1∼24 carbon atoms, acidic group, hydroxyl group, nitro group, or halogen atom; at least one of R¹∼R⁴ is an acidic group or its salt; and the acidic group is a sulfonic acid group or carboxy group.)
[10'] The conductive composition described in any of [1']∼[9'], in which the water-soluble polymer (b) is represented by general formula (6) below. 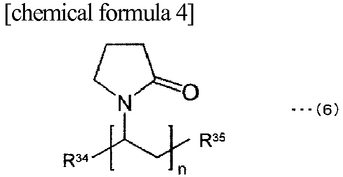 (In formula (6), R³⁴ and R³⁵ independently represent a hydrogen, hydroxyl group, carboxyl group, alkyl group-substituted carboxyl group, aralkylthio group-substituted carboxyl group, or arylthio group-substituted carboxyl group, alkylthio group, aralkylthio group or arylthio group; at least one of R³⁴ and R³⁵ is an alkylthio group, aralkylthio group or arylthio group; "n" indicates an integer of 10∼100000; and R³⁴ and R³⁵ differ depending on the initiator, chain-transfer agent or solvent used for reactions, since the cleavage by a polymerization initiator, a chain-transfer agent, or a polymerization termination mechanism makes different substituents.)
[11'] A method for forming a conductor, including a step for forming a film by coating the conductive composition described in any of [1']∼[10'] on a chemically amplified resist layer formed on at least one surface of a substrate.
[12'] The method for forming a conductor described in [11'], further including a step for leaving the film at room temperature or applying heat to the film after the film was formed.
[13'] The method for forming a conductor described in [12'], in which the temperature for applying heat is 40∼250°C.
[14'] A conductor having a chemically amplified resist layer formed on at least one surface of a substrate and a layer formed on the chemically amplified resist layer by using the composition described in any of [1']∼[10'].
[15'] A mask blank having a chemically amplified resist layer formed on at least one surface of a substrate and a layer formed on the chemically amplified resist layer by using the composition described in any of [1']∼[10'].
[16'] A method for forming a resist pattern by using the mask blank described in [15'].
[17'] The conductive composition described in [1']∼[10'], in which the water-soluble polymer (b) has a mass average molecular weight of 1500 or greater and a surface tension of 10∼60 mN/m.
[18'] A method for producing the water-soluble polymer (b) described in [17'], in which a vinyl monomer having a hydrophilic group is polymerized in the presence of a polymerization initiator and a chain-transfer agent having at least 13 carbon atoms so as to produce a polymer having a hydrophilic group and a terminal hydrophobic group having at least 13 carbon atoms.

### EFFECTS OF THE INVENTION

The conductive composition related to the present invention exhibits excellent coating properties and conductivity, and is capable of forming a film that is less likely to adversely affect the laminated layer such as resist coated on a substrate.

### PREFERRED EMBODIMENTS TO CARRY OUT THE INVENTION

In the following, the present invention is described in detail.

In the embodiments of the present invention, for a material to be "conductive" means it has a surface resistance value of 10¹¹ Ω or lower. A surface resistance value is obtained from the difference in potential between electrodes when a constant electrical current is applied. For example, the surface resistance value [Ω] of a conductor is determined by a two-terminal method (distance between electrodes: 20 mm) using Hiresta MCP-HT260 (made by Mitsubishi Chemical Analytech Co., Ltd.) In the present application, a "conductor" means a product having a portion that is set to be conductive as defined above.

In addition, being "soluble" in the present application means at least 0.1 gram of a material is homogeneously dissolved in 10 grams of a solvent (liquid temperature of 25°C) selected from (1) water, (2) water containing at least one component selected from among bases and basic salts, (3) water containing acid, and (4) a mixture of water and a water-soluble organic solvent.

Being "homogeneously dissolved" means a condition in which a sample is dispersed in a solution without being precipitated, and the concentration is the same in any portion of the solution.

In the embodiment of the present invention, "terminal" of a "terminal hydrophobic group" means a site excluding the repeating unit of a polymer, and a "terminal hydrophobic group" means a hydrophobic group that is located at the "terminal" site. Here, examples of a "hydrophobic group" are those having at least 13 carbon atoms.

### <Conductive Composition>

A conductive composition of the present invention includes conductive material (A), which comprises a conductive polymer (a) comprising a sulfonic acid group or carboxyl acid group, and a water-soluble polymer (b) containing a hydrophilic group and a terminal hydrophobic group having at least 13 carbon atoms, wherein the hydrophilic group of the water-soluble polymer (b) comprises a nitrogen atom.

Also, a conductive composition according to an embodiment of the present invention is preferred to contain the conductive material (A), the water-soluble polymer (b), and a solvent (c).

### [Conductive Material (A)]

Examples of conductive material (A) related to the conductive composition according to an embodiment of the present invention are conductive polymer (a), ionic liquid, ionic polymers and the like. They may be used alone or in combination thereof.

### [Conductive Polymer (a)]

The conductive polymer (a) is a conductive polymer containing at least one group selected from among sulfonic acid groups and carboxyl acid groups.

More specifically, considering solubility, it is preferred to use conductive polymers or the like described in the following literatures: JPS61-197633A, JPS63-39916A, JPH1-301714A, JPH5-504153A, JPH5-503953A, JPH4-32848A, JPH4-328181A, JPH6-145386A, JPH6-56987A, JPH5-226238A, JPH5-178989A, JPH6-293828A, JPH7-118524A, JPH6-32845A, JPH6-87949A, JPH6-256516A, JPH741756A, JPH748436A, and JPH4-268331A

Specific examples of conductive polymer (a) are π-conjugated conductive polymers having at least one group selected from among the following as its repeating unit: phenylene vinylene, vinylene, thienylene, pyrrolylene, phenylene, iminophenylene, isothianaphthene, furylene, and carbazolylene where the α-position or β-position of a bond is substituted with at least one group selected from among sulfonic acid groups and carboxyl acid groups.

In addition, when a π-conjugated conductive polymer contains at least one group selected from iminophenylene and carbazolylene as its repeating unit, examples of such a conductive polymer are those having at least one group selected from sulfonic acid groups and carboxyl acid groups positioned on the nitrogen atom of a repeating unit; or those having an alkyl group substituted with at least one group selected from sulfonic acid groups and carboxyl acid groups, or an alkyl group with ether bonds, positioned on the nitrogen atom of the repeating unit.

Among those listed above, considering conductivity and solubility, it is preferred to use a conductive polymer that contains as a repeating unit at least one group selected from among thienylene, pyrrolylene, iminophenylene, phenylene vinylene, carbazolylene, and isothianaphthene where the β-position of the bond is substituted with at least one group selected from among sulfonic acid groups and carboxyl acid groups.

In addition, when conductivity and solubility are considered, conductive polymer (a) related to the conductive composition according to an embodiment of the present invention is preferred to have a repeating unit represented by general formula (1) below.

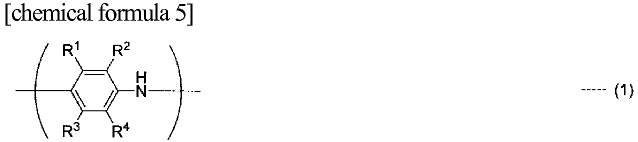

In formula (1), R¹∼R⁴ independently represent a hydrogen atom, straight- or branched-chain alkyl group having 1∼24 carbon atoms, straight- or branched-chain alkoxy group having 1∼24 carbon atoms, acidic group, hydroxyl group, nitro group, or halogen atom (-F, -Cl, -Br or I); at least one of R¹∼R⁴ is an acidic group or its salt; and the acidic group is a sulfonic acid group or carboxylic acid group.

Here, a sulfonic acid group and a carboxyl acid group may be contained as an acid (namely, -SO₃H, or -COOH), or it may be contained as an ion (namely, -SO₃⁻, -COO⁻).

In addition, a "salt" indicates at least one salt selected from among alkali metal salts, alkaline earth metal salts, ammonium salts and substituted ammonium salts.

As for a repeating unit represented by formula (1) above, it is preferred that any one of R¹∼R⁴ be a straight- or branched-alkoxy group having 1∼4 carbon atoms, another one be a sulfonic acid group, and the rest be hydrogen atoms, because such structures result in easy production.

Also, from the viewpoints of conductivity and solubility, conductive polymer (a) is preferred to have at least one repeating unit selected from repeating units represented by formulas (2)∼(4) below.

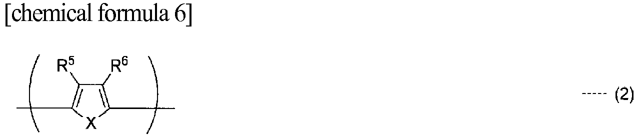

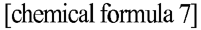

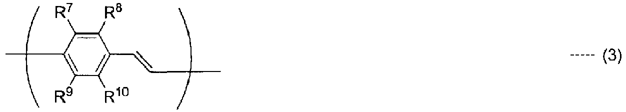

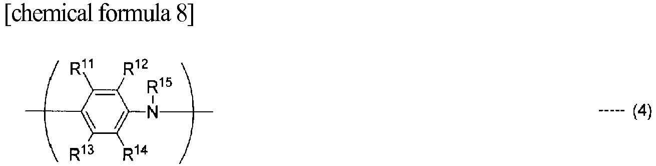

In formulas (2)∼(4) above, "X" represents a sulfur atom or -NH-.

R⁵∼R¹⁵ independently represent a hydrogen atom, halogen atom, -SO₃H, -R¹⁶SO₃H, -OCH₃, -CH₃, -C₂H₅, -F, -Cl, -Br, -I, -N(R¹⁷)₂, -NHCOR¹⁷, -OH, -O-, -SR¹⁷, -OR¹⁷, -OCOR¹⁷, -NO₂, -COOH, -R¹⁶COOH, -COOR¹⁷, -COR¹⁷, -CHO, or -CN.

In the above, R¹⁶ represents an alkylene group having 1∼24 carbon atoms, arylene group having 1∼24 carbon atoms, or aralkylene group having 1∼24 carbon atoms.

R¹⁷ represents an alkyl group having 1∼24 carbon atoms, aryl group having 1∼24 carbon atoms, or aralkyl group having 1∼24 carbon atoms.

However, regarding R⁵ and R⁶ in formula (2), R⁷∼R¹⁰ in formula (3), and R¹¹∼R¹⁵ in formula (4), at least one in each formula is a group selected from among -SO₃H, -R¹⁶SO₃H, -COOH, -R¹⁶COOH, or their alkali metal salts, ammonium salts and substituted ammonium salts.

In a conductive polymer (a), relative to the total number (total molar number) of aromatic rings in the polymer, the content of a sulfonic acid group and a carboxyl acid group is preferred to be 50 mol% or greater, more preferably 70 mol% or greater, even more preferably 90 mol% or greater, most preferably 100 mol%. A content of 50 mol% or greater is preferred, since the conductive polymer exhibits excellent solubility.

The content means the value calculated from the ratio of monomers supplied for producing the conductive polymer (a).

In addition, except for a sulfonic acid group or carboxyl acid group, substituents on the aromatic ring in the repeating unit of a conductive polymer (a) are each preferred to be an electron-donating group for the purpose of providing reactivity to monomers. In particular, alkyl groups having 1∼24 carbon atoms, alkoxy groups having 1∼24 carbon atoms, halogen groups (-F, -Cl, -Br, or I) or the like are preferred. Among them, alkoxy groups having 1∼24 carbon atoms are most preferred from the viewpoint of donating electrons.

Among the above-described combinations for the repeating unit of a conductive polymer (a) related to the conductive composition according to an embodiment of the present invention, the polymer (a) is preferred to have a structure represented by general formula (5) below from the viewpoint of solubility. Among the structures represented by formula (5), especially preferred is poly(2-sulfo-5-methoxy-1,4-iminophenylene).

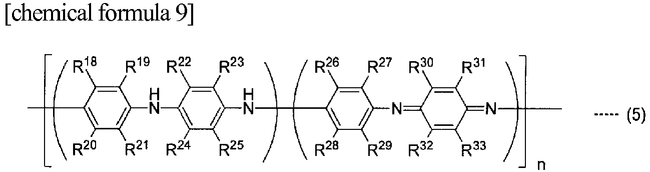

In formula (5), R¹⁸∼R³³ independently represent a hydrogen atom, straight- or branched-chain alkyl group having 1∼4 carbon atoms, straight- or branched-chain alkoxy group having 1∼4 carbon atoms, acidic group, hydroxyl group, nitro group, or halogen group (-F, -Cl, -Br or I); at least one of R¹⁸∼R³³ is an acidic group. In addition, "n" indicates the degree of polymerization. In the embodiments of the present invention, "n" is preferred to be an integer of 5∼2500. An acidic group among R¹⁸∼R³ is the same as that described above.

To enhance the conductivity of a conductive composition according to an embodiment of the present invention, at least part of the acidic group in a conductive polymer (a) is preferred to be free acid.

Also, from the viewpoint of conductivity, solubility and film-forming properties, the mass average molecular weight of a conductive polymer (a) is preferred to be 2000∼one million, more preferably 3000∼800000, even more preferably 5000∼500000, especially preferably 10000∼100000, in terms of sodium polystyrene sulfonate when analyzed by gel permeation chromatography (hereinafter referred to as "GPC").

If the mass average molecular weight of a conductive polymer (a) is less than 2000, the solubility is excellent, but the conductivity and film-forming properties may be insufficient.

On the other hand, if the mass average molecular weight exceeds one million, the conductivity is excellent but solubility may be insufficient.

Here, "film-forming properties" mean film is formed with homogeneous coating results while excellent cissing resistance is exhibited. Such properties may be evaluated by spin coating on glass or the like.

Producing a conductive polymer (a) is not limited specifically as long as the effects of the present invention are achieved, and any known method may be employed.

In particular, a polymerizable monomer having a repeating unit such as that described above is polymerized by various synthesizing methods such as chemical oxidation and electrolytic oxidation. For such methods, synthesizing methods proposed by the inventors of the present invention in JPH7-196791A and JPH7-324132Amay be employed.

In the conductive composition according to an embodiment of the present invention, the content of a conductive polymer (a) is preferred to be 0.01∼50 mass%, more preferably 0.05∼20 mass%, relative to the total mass (100 mass%) of the conductive composition.

More specific examples of a π-conjugated conductive polymer used as a conductive polymer (a) are polythiophenes such as polythiophene, poly(3-methylthiophene), poly(3-ethylthiophene), poly(3-propylthiophene), poly(3-butylthiophene), poly(3-hexylthiophene), poly(3-heptylthiophene, poly(3-octylthiophene), poly(3-decylthiophene), poly(3-dodecylthiophene), poly(3-octadecylthiophene), poly(3-bromothiophene), poly(3-chlorothiophene), poly(3-iodothiophene), poly(3-cyanothiophene), poly(3-phenylthiophene), poly(3,4-dimethylthiophene), poly(3,4-dibutylthiophene), poly(3-hydroxythiophene), poly(3-methoxythiophene), poly(3-ethoxythiophene), poly(3-butoxythiophene), poly(3-hexyloxythiophene), poly(3-heptyloxythiophene), poly(3-octyloxythiophene), poly(3-decyloxythiophene), poly(3-dodecyloxythiophene), poly(3-octadecyloxythiophene), poly(3,4-dihydroxythiophene), poly(3,4-dimethoxythiophene), poly(3,4-diethoxythiophene), poly(3,4-dipropoxythiophene), poly(3,4 dibutoxythiophene), poly(3,4-dihexyloxythiophene), poly(3,4-diheptyloxythiophene), poly(3,4-dioctyloxythiophene), poly(3,4-didecyloxythiophene), poly(3,4-didodecyloxythiophene), poly(3,4-ethylenedioxythiophene), poly(3,4-propylenedioxythiophene), poly(3,4-butenedioxythiophene), poly(3-methyl-4-methoxythiophene), poly(3-methyl-4-ethoxythiophene), poly(3-carboxythiophene), poly(3-methyl-4-carboxythiophene), poly(3-methy-4-carboxyethylthiophene), and poly(3-methyl-4-carboxybutylthiophene).

Examples of polypyrroles are polypyrrole, poly(N-methylpyrrole), poly(3-methylpyrrole), poly(3-ethylpyrrole), poly(3-n-propylpyrrole), poly(3-butylpyrrole), poly(3-octylpyrrole), poly(3-decylpyrrole), poly(3-dodecylpyrrole), poly(3,4-dimethylpyn-ole), poly(3,4-dibutylpyrrole), poly(3-carboxypyrrole), poly(3-methyl-4-carboxypyrrole), poly(3-methyl-4-carboxyethylpyrrole), poly(3-methyl-4-carboxybutylpyrrole), poly(3-hydroxypyrrole), poly(3-methoxypyrrole), poly(3-ethoxypyrrole), poly(3-butoxypyrrole), poly(3-hexyloxypyrrole), poly(3-methyl-4-hexyloxypyrrole), and poly(3-methyl-4-hexyloxypyrrole).

Examples of polyanilines are polyaniline, poly(2-methylaniline), poly(3-isobutylaniline), poly(2-aniline-sulfonic acid), poly(3-aniline sulfonic acid), and poly(2-aminoanisole-4-sulfonic acid).

### (Ionic Liquid)

For an ionic liquid to be used as conductive material (A), salts of organic compounds in a liquid state at room temperature are preferred, for example, imidazolium salts, pyridinium salts, ammonium salts, and phosphonium salts.

Examples of imidazolium salts as ionic liquids are 1,3-dimethyl-imidazolium·methyl sulfate, 1-ethyl-3-methylimidazolium·bis(pentafluoroethyl sulfonyl)imide, 1-ethyl-3-methylimidazolium·bis(trifluoroethyl sulfonyl)imide, 1-ethyl-3-methylimidazolium·bromide, 1-ethyl-3-methylimidazolium chloride, 1-ethyl-3-methylimidazolium nitrate, 1-ethyl-3-methylimidazolium hexafluorophosphate, 1-ethyl-3-methylimidazolium·chloride, 1-ethyl-3-methylimidazolium·nitrate, 1-ethyl-3-methylimidazolium·hexafluorophosphate, 1-ethyl-3-methylimidazolium·tetrafluoroborate, 1-ethyl-3-methylimidazolium·tosylate, 1-ethyl-3-methyl imidazolium·trifluoromethane sulfonate, 1-n-butyl-3-methylimidazolium·trifluoromethanesulfonate, 1-butyl-3-methylimidazolium·bis(trifluoromethylsulfonyl)imide, 1-butyl-3-methylimidazolium·bromide, 1-butyl-3-methylimidazolium·chloride, 1-butyl-3-methylimidazolium·hexafluorophosphate, 1-butyl-3-methylimidazolium·2-(2-methoxyethoxy)ethyl sulfate, 1-butyl-3-methylimidazolium·methylsuliate, 1-butyl-3-methylimidazolium·tetrafluoroborate, 1-hexyl-3-methylimidazolium·chloride, 1-hexyl-3-methylimidazolium·hexafluorophosphate, 1-hexyl-3-methylimidazolium·tetrafluoroborate, 1-methyl-3-octylimidazolium·chloride, 1-methyl-3-octylimidazolium·tetrafluoroborate, 1,2-dimethyl-3-propyl octylimidazolium·tris(trifluoromethyl sulfonyl)methide, 1-butyl-2,3-dimethylimidazolium·chloride, 1-butyl-2,3-dimethylimidazolium·hexafluorophosphate, 1-butyl-2,3-dimethylimidazolium·tetrafluoroborate, 1-methyl-3-(3,3,4,4,5,5,6,6,7,7,8,8,8-tridecafluorooctyl)imidazolium·hexafluorophosphate, and 1-butyl-3-(3,3,4,4,5,5,6,6,7,7,8,8,8-tridecafluorooctyl)imidazolium-hexafluorophosphate.

Examples of pyridinium salts as ionic liquids are 3-methyl-1-propylpyridinium·bis(trinuoromethylsulfonyl)imide, 1-butyl-3-methylpyndinium·bis(trifluoromethylsulfonyl)imide, 1-propyl-3-methylpyridinium·trifluoromethanesulfonate, 1-butyl-3-methylpyridinium·trifluoromethanesulfonate, 1-buty-4-methylpyridinium·bromide, 1-butyl-4-methylpyridinium·chloride, 1-butyl-4-methylpyridinium·hexafluorophosphate, and 1-butyl-4-methylpyridinium·tetrafluoroborate.

Examples of ammonium salts as ionic liquids are etrabutylammomum·heptadecafluorooctanesulfonate, tetrabutylammonium·nonafluorobutanesulfonate, tetrapentylammonium·methanesulfonate, tetrapentyl ammonium·thiocyanate, andmethyl-tri-n-butylammonium·methylsulfate.

Examples of phosphonium salts as ionic liquids are tetrabutylphosphonium·methanesulfonate, tetrabutylphosphonium·p-toluenesulfonate, trihexyl tetradecyl phosphonium·bis(trifluoroethylsulfonyl)imide, trihexyl tetradecyl phosphonium·bis(2,4,4-trimethylpentyl)phosphinate, trihexyl tetradecyl phosphonium·bromide, trihexyl tetradecyl phosphonium·chlotide, trihexyl tetradecyl phosphonium·decanoate, trihexyl tetradecyl phosphonium·hexafluoro phosphinate, triethyl tetradecyl phosphonium·tetrafluoroborate, and tributyl methyl phosphonium·tosylate.

### (Ionic Polymer)

Examples of an ionic polymer used as conductive material (A) (hereinafter may also be referred to as an ionic polymer compound) are anionic polymer compounds such as those in JPS49-23828B, JPS49-23827B, and JPS47-28937B; ionene-type polymers having a leaving group in the main chain such as those in JPS55-734B, JPS50-54672A, JPS59-14735B JPS57-18175B, JPS57-18176B, and JPS57-56059B; cationic pendant polymers having a cationic leaving group in a side chain such as those in JPS53-13223B, JPS57-15376B, JPS53-45231A, JPS55-145783A, JPS55-65950A, JPS55-67746A, JPS57-11342A, JPS57-19735A, and JPS58-56858B; and so on.

### [Water-Soluble Polymer (b)]

In a conductive composition of the present invention, a water-soluble polymer (b) indicates such a polymer that contains a terminal hydrophobic group having at least 13, preferably at least 14, carbon atoms.

In a conductive composition according to an embodiment of the present invention, a water-soluble polymer (b) works as a surfactant.

When a water-soluble polymer (b), containing a terminal hydrophobic group having at least a certain number of carbon atoms, is combined as a surfactant with the aforementioned conductive polymer (a), the conductive composition achieves excellent coating properties and is capable of forming a film that exerts less impact on the laminated layer such as resist on a substrate.

In addition, the water-soluble polymer (b) includes a nitrogen-containing functional group, and the nitrogen-containing functional group is preferred to be an amide group, when its solubility is considered.

The terminal hydrophobic group is not limited specifically, as long as it includes an alkyl group, aralkyl group and aryl group.

Examples of a terminal hydrophobic group are an alkyl group, aralkyl group, aryl group, alkoxy group, aralkyloxy group, aryloxy group, alkylthio group, aralkylthio group, arylthio group, primary or secondary alkylamino group, aralkylamino group, arylamino group and the like.

From the viewpoints of solubility and surface activity property, the water-soluble polymer (b) in a conductive composition according to an embodiment of the present invention is preferred to have a terminal hydrophobic group that contains at least one group selected from among alkyl chains having 13∼100 carbon atoms, aralkyl chains having 13∼100 carbon atoms, and aryl chains having 13∼100 carbon atoms.

In addition, the terminal hydrophobic group is more preferred to contain at least one group selected from among alkyl groups having 13∼70 carbon atoms, aralykyl groups having 13∼70 carbon atoms, and aryl groups having 13∼70 carbon atoms, especially preferably alkyl groups having 13∼30 carbon atoms, aralykyl groups having 13∼30 carbon atoms, and aryl groups having 13∼30 carbon atoms.

In the above, the terminal hydrophobic group is preferred to contain at least one group selected from among the alkyl groups, aralykyl groups and aryl groups; from the viewpoints of solubility and surface activity property, more preferably, selected from among the alkylthio groups having an alkyl group and a sulfur atom, the aralykyl groups having an aralkyl group and a sulfur atom, and the aryl groups having an aryl group and a sulfur atom.

Especially, alkylthio groups are preferred from the viewpoint of solubility and surface activity property.

The mass average molecular weight of the water-soluble polymer (b) is preferred to be 1000∼one million, more preferably 2,000∼100000, especially preferably 2500∼10000.

The mass average molecular weight of the water-soluble polymer (b) is determined by GPC (gel permeation chromatography).

The main chain structure of the aforementioned water-soluble polymer (b) is not limited specifically as long as it is water soluble and a homopolymer of vinyl monomers or a copolymer of other vinylmonomers, and the effects of the present invention are achieved. In addition, the main chain structure is preferred to include a nitrogen-containing functional group.

As for the aforementioned nitrogen-containing functional group, it is preferred to have an amide bond. Examples of a vinyl monomer with an amide bond are acrylamides and their derivatives, N-vinyl lactams and the like. Specific examples are acrylamide, N,N-dimethylacrylamide, N-isopropylacrylamide, N,N-diethyl-acrylamide, N,N-dimethylaminopropyl acrylamide, t-butyl acrylamide, diacetone acrylamide, N,N'-methylenebisacrylamide, N-vinyl-N-methyl acrylamide, N-vinyl-2-pyrrolidone, N-vinyl caprolactam, and the like. Moreover, when considering solubility, especially preferred among the those listed above are acrylamide, N-vinylpyrrolidone, N-vinylcaprolactam, and the like.

The method for introducing a terminal hydrophobic group into the water-soluble polymer (b) is not limited specifically as long as the effects of the present invention are achieved; however, a terminal hydrophobic group is preferred to be introduced by simply selecting a chain-transfer agent when vinyl polymerization is conducted.

Namely, a water-soluble polymer (b) containing a terminal hydrophobic group having at least 13 carbon atoms is produced by polymerizing a vinyl monomer in the presence of a polymerization initiator and a chain-transfer agent having at least 13 carbon atoms.

In such a case, a chain-transfer agent is not limited specifically as long as the above terminal hydrophobic group is introduced and the effects of the present invention are achieved. Preferred examples of a chain-transfer agent are thiols, disulfides, and thioethers and the like, since it is easier to obtain a preferred terminal hydrophobic group such as alkylthio groups, aralkylthio groups and arylthio groups.

Preferred examples of a polymerization initiator are those used for vinyl polymerization such as azo initiators, peroxide initiators, and organic metals.

The number of repeated units in the main chain structure of a water-soluble polymer (b), namely, the polymerization degree of the above vinyl monomer, is preferred to be 10∼100000, more preferably 15∼1000, especially preferably 20∼200, considering the solubility of the water-soluble polymer (b).

In addition, regarding the molecular weight of the main chain structure (hereinafter may also be referred to as "molecular weight of the water-soluble site") and the molecular weight of the terminal hydrophobic site (hereinafter may also be referred to as "molecular weight of the hydrophobic site") of the water-soluble polymer (b), the ratio (molecular weight of the water-soluble site) / (molecular weight of the hydrophobic site) is preferred to be 1∼1500, more preferably 5∼1000, from the viewpoint of surface activity property. Here, the "molecular weight of the water-soluble site" and the "molecular weight of the hydrophobic site" are calculated from the mass average molecular weight of the obtained water-soluble polymer (b) and the ratio of the amount of a supplied monomer that forms the main chain structure to the amount of a supplied chain-transfer agent that forms the terminal hydrophobic site.

In the above, when considering solubility and the like, a water-soluble polymer (b) is preferred to be represented by general formula (6) below. 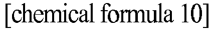 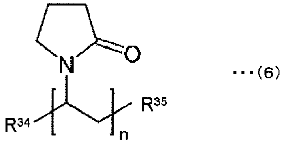 (in formula (6), R³⁴ and R³⁵ independently represent a hydrogen atom, hydroxyl group, carboxyl group, alkyl group-substituted carboxyl group, aralkylthio group-substituted carboxyl group, or arylthio group-substituted carboxyl group, alkylthio group, aralkylthio group or arylthio group; at least one of R³⁴ and R³⁵ is an alkylthio group, aralkylthio group or arylthio group; and "n" indicates an integer number of 10∼100000)

Unlike a conventional surfactant, a water-soluble polymer (b) expresses surfactant activity by the main chain structure (water-soluble site) and a terminal hydrophobic group (hydrophobic site).

Since no acid or base is included and no byproduct is generated through hydrolysis, such a polymer (b) enhances coating properties without negatively affecting the substrate and the laminated layer, such as a resist, coated on a substrate.

Moreover, by setting the terminal hydrophobic group of a water-soluble polymer (b) to have at least 13 carbon atoms, preferably at least 14 carbon atoms, the degree of entanglement of carbon chains increases in the film, and a strong film is thereby obtained.

Accordingly, when a film is formed on a resist layer by coating the conductive composition related to an embodiment of the present invention, a low-molecular component in the composition, for example, a component with a molecular weight of 5000 or lower, is suppressed from migrating into the interface with the resist, and the resist surface is thereby suppressed from dissolving.

Therefore, when a conductor includes a film formed by coating on the resist surface a conductive composition containing the water-soluble polymer (b), the resist is unlikely to be affected even when the conductor is used under high-temperature conditions of 100°C or higher.

In addition, when considering fluidity, the glass transition temperature of a water-soluble polymer (b) is preferred to be 60°C∼250°C, more preferably 65°C∼200°C, especially preferably 70°C∼150°C.

The amount of a water-soluble polymer (b) is preferred to be 0.01∼20 parts by mass, more preferably 0.01∼15 parts by mass, relative to 100 parts by mass of the later-described solvent (c).

Also, the content of a water-soluble polymer (b) in the conductive composition according to an embodiment of the present invention is preferred to be 0.01∼50 mass%, more preferably 0.1∼20 mass%, relative to the total mass (100 mass%) of the conductive composition.

Moreover, the ratio of the water-soluble polymer (b) to conductive polymer (a) is preferred to be 0.1:9.9∼9.9:0.1, more preferably 1:9∼9:1.

The surface tension of a water-soluble polymer (b) is preferred to be 10∼60 mN/m.

The surface tension of a water-soluble polymer (b) is determined by, for example, the Wilhelmy method (plate method, vertical plate method). An example of a surface tensiometer for the Wilhelmy method is "Full Automatic Surface Tensiometer CBVP-Z" made by Kyowa Interface Science Co., Ltd.

### [Solvent (c)]

A solvent (c) in the conductive composition according to an embodiment of the present invention is not limited specifically as long as the effects of the present invention are achieved, and the solvent is capable of dissolving a conductive polymer (a) and water-soluble polymer (b). Examples of a solvent (c) are water; and water combined with the following; alcohols such as methanol, ethanol, isopropyl alcohol, propyl alcohol and butanol; ketones such as acetone and ethyl isobutyl ketone; ethylene glycols such as ethylene glycol and ethylene glycol methyl ether; propylene glycols such as propylene glycol, propylene glycol methyl ether, propylene glycol ethyl ether, propylene glycol butyl ether and propylene glycol propyl ether; amides such as dimethylformamide and dimethylacetamide; pyrrolidones such as N-methyl-pyrrolidone, and N-ethyl-pyrrolidone; and so on.

When a mixture with water is used as a solvent (c), a ratio of water and organic solvent (mass ratio) is preferred to be 1/100∼100/1, more preferably 2/100∼100/2.

Also, in the conductive composition according to an embodiment of the present invention, a preferred content of solvent (c) is 2∼10000 parts by mass, more preferably 50∼10000 parts by mass, relative to 1 part by mass of conductive polymer (a).

### [Polymer Compound (d)]

The conductive composition related to the present invention can contain a polymer compound (d) to enhance the film strength and surface smoothness.

Specific examples of a polymer compound (d) are polyvinyl alcohol derivatives such as polyvinyl formal and polyvinyl butyral; polyacrylamides such as polyacrylamide, poly(N-t-butyl acrylamide), and polyacrylamide methylpropane sulfonate; polyvinylpyrrolidones; polyacrylic acids; water-soluble alkyd resins; water-soluble melamine resins; water-soluble urea resins; water-soluble phenolic resins; water-soluble epoxy resins; water-soluble polybutadiene resins; water-soluble acrylic resins; water-soluble urethane resins; water-soluble acrylic-styrene copolymer resins; water-soluble vinyl acetate-acrylic copolymer resins; water-soluble polyester resins; water-soluble styrene-maleic acid copolymer resins; water-soluble fluorocarbon resins; and copolymers thereof.

Moreover, if applicable, the conductive composition according to an embodiment of the present invention may contain various additives such as pigments, antifoaming agents, ultraviolet absorbers, antioxidants, heat resistance enhancers, leveling agents, dripping inhibitors, matting agents, and preservatives.

### [Conductor and Laminate]

The conductor according to an embodiment of the present invention contains a substrate and a film formed by coating the conductive composition on at least one surface of the substrate.

In addition, when a conductor contains a substrate, a resist layer formed on at least one surface of the substrate, and a film formed by coating the conductive composition on the resist layer, such a conductor may also be referred to as a laminate.

The method for coating the conductive composition on a substrate is not limited specifically as long as the effects of the present invention are achieved. Examples of such a method are spin coating, spray coating, dip coating, roll coating, gravure coating, reverse coating, roll brushing, air-knife coating, curtain coating, and the like.

A substrate is not limited specifically as long as the effects of the present invention are achieved. Examples are molded products and films of various polymer compounds, for example, polyester resins such as PET and PBT, polyolefin resins represented by polyethylene and polypropylene, polyvinyl chlorides, nylons, polystyrenes, polycarbonates, epoxy resins, fluorocarbon resins, polysulfones, polyimides, polyurethanes, phenolic resins, silicone resins, and synthetic papers; various wafers such as paper, iron, glass, quartz glass, and silicon; substrates made of aluminum, copper, zinc, nickel, and stainless steel; and substrates formed by coating various types of coating material, photosensitive resins, resists and the like on surfaces of the substrates listed above.

When a conductive composition is coated on a substrate, such a process may be conducted prior to, during or after the production process of a substrate, for example, uniaxial stretching process, biaxial stretching process, molding, embossing or the like.

In addition, since the conductive composition according to an embodiment of the present invention exhibits excellent coating properties, a film may be formed by further coating the conductive composition on the substrate where various types of coating material and photosensitive material are already coated.

The method for producing a conductor according to an embodiment of the present invention may be carried out by coating and drying the conductive composition on at least one surface of the substrate to form a coated film, and then by leaving the film at room temperature (20°C∼30°C) for one to 60 minutes or by applying heat thereon.

When heat is applied, the temperature is preferred to be in a range of 40°C∼250°C, more preferably 60°C∼200°C, from the viewpoint of conductivity. Also, when considering stability, the processing time is preferred to be within one hour, more preferably within 30 minutes.

The conductive composition according to an embodiment of the present invention is capable of forming a conductor having an insoluble film, or a removable soluble film (namely, conductive polymer film) by applying heat after the conductor is formed.

As a result, the conductor may be used as both permanent antistatic film and temporary antistatic film during the production process.

Namely, an aspect of the method for producing a conductor according to an embodiment of the present invention is as follows: coating the conductive composition on at least one surface of the substrate; forming a film by drying the coated conductive composition; and leaving the film at room temperature (25°C∼30°C) for one to 60 minutes, or applying heat thereon.

The heating temperature for the heating process is 40°C∼250°C, and the heating time is within one hour.

Another aspect of the method for producing a conductor according to an embodiment of the present invention is as follows: coating the conductive composition on a chemically amplified resist layer formed on at least one surface of a substrate; forming a film by drying the coated conductive composition; and leaving the film at room temperature (25°C∼30°C) for one to 60 minutes, or applying heat thereon.

The heating temperature for the heating process is 40°C∼250°C, and the heating time is within one hour.

An aspect of the present invention is a mask blank that includes a chemically amplified resist layer formed on at least one surface of a substrate and a layer formed on the chemically amplified resist layer by coating the conductive composition according to an embodiment of the present invention.

Another aspect of the present invention is a method for forming a resist pattern by using the mask blank.

The method for forming resist patterns by using mask blanks containing a layer made of the conductive composition is capable of preventing a charge-up of electrons while patterns are drawn by electron beams.

### EXAMPLES

In the following, the present invention is described in further detail by referring to examples. However, the present invention is not limited to the examples below.

### <Evaluation of Molecular Weight>

A 0.1 wt% solution of a water-soluble polymer (b) was filtrated using a 0.45 µm membrane filter to prepare a sample. The sample was analyzed by GPC under the conditions specified below to determine the mass average molecular weight of the water-soluble polymer (b).
Measuring instrument: TOSOH GPC-8020 (made by Tosoh Corporation)
Eluent: 0.2M-NaNO₃-DIW/acetonitrile=80/20 (v/v)
Column temperature: 30°C
Calibration curve: prepared by using an EasiVial™ polyethylene glycol/oxide kit (made by Polymer Laboratories)

### <Evaluation of Conductivity>

A conductive composition was spin coated (2000 rpm×60 sec.) on a glass substrate, and was placed on a hot plate to apply heat at 80°C for two minutes. Accordingly, an approximate film thickness of 30 nm was formed and a conductor was obtained.

The surface resistance value [Ω] of the conductor was measured by a two-terminal method (distance between electrodes: 20 mm) using Hiresta MCP-HT260 (made by Mitsubishi Chemical Analytech).

### <Evaluation of Development Speed>

A chemically amplified resist for electron beam lithography (for example, commercially available negative resist FEN-271 or the like, made by Fuji Film Electronics Materials Co., Ltd; hereinafter referred to as "resist") was used, and its development speed was evaluated through the following steps.
(1) Forming resist film: on a 4-inch silicon wafer (substrate), a 0.4 µm-thick chemically amplified resist was spin coated at 2000 rpm/60 sec., and the resist was prebaked at 120°C for 90 seconds to remove the solvent.
(2) Forming antistatic film: on the outer side of the center (midpoint between the center and edge) of the resist surface coated on a substrate, 0.1 mL of the conductive composition according to an embodiment of the present invention was dropped and was spin coated at 2000 rpm/60 sec. using a spin coater. Accordingly, a 20 nm-thick antistatic film was formed on a portion of the surface.
(3) Baking: the substrate with laminated antistatic film and resist was heated on a hot plate at 130°C for 5 minutes under ambient air conditions, and the substrate was left standing at room temperature (25°C) for 90 seconds under ambient air conditions.
(4) Washing with water: the antistatic film was washed with 20 mL of water and rotated on a spin coater at 2000 rpm/60 sec. to remove the water on the resist surface.
(5) Developing: 20 mL of a developing solution made of a 2.38 mass% tetramethylammonium hydroxide (TMAH) solution was dropped on the resist surface and was left standing for 20 seconds. Then, the substrate was rotated at 2000 rpm to remove the developing solution, and the rotation was maintained for 60 seconds to dry the substrate surface.
(6) The film thicknesses of a portion covered by the antistatic film and a portion not covered by the antistatic film were compared by visually observing the differences in interference colors. When the thickness of the antistatic film-covered portion was thinner than the non-covered portion, it was evaluated as "-" (minus), which means the antistatic film accelerated the development speed (+: plus). In addition, when the substrate surface was exposed in the antistatic film-covered portion, it was evaluated as "--" (double minus), which means the antistatic film further accelerated the development speed (++: double plus).

### <Evaluation of Reduction in Film Thickness>

### (Reduction in Resist Thickness)

A chemically amplified resist for electron beam lithography (for example, commercially available positive resist FEP-171 or the like, made by Fuji Film Electronics Materials; hereinafter referred to as "resist") was used, and the reduction in resist film thickness was evaluated through the following steps.
(1) Forming resist film: on a 4-inch silicon wafer (substrate), a 0.4 µm-thick chemically amplified resist was spin coated at 2000 rpm/60 sec., and the resist was prebaked at 130°C for 90 seconds to remove the solvent.
(2) Measuring resist film thickness: part of the resist formed on the substrate was removed, and the initial resist film thickness "A" (nm) was measured from the substrate surface set as the base position by using a stylus profilometer (Stylus Profiler P-16+, made by KLA-Tencor Corporation).
(3) Forming antistatic film: on the resist surface coated on the substrate, 2 mL of the conductive composition according to an embodiment of the present invention was dropped to cover the entire resist surface and spin coated at 2000 rpm/60 sec. using a spin coater. Accordingly, a 30 nm-thick antistatic film was formed.
(4) Baking: the substrate with laminated antistatic film and resist was heated on a hot plate at 120°C for 20 minutes under ambient air conditions, and the substrate was kept standing at room temperature (25°C) for 90 seconds under ambient air conditions.
(5) Washing with water: the antistatic film was washed with 20 mL of water and the substrate was rotated on a spin coater at 2000 rpm/60 sec. to remove the water on the resist surface.
(6) Developing: 20 mL of a developing solution made of a 2.38 mass% tetramethylammonium hydroxide (TMAH) solution was dropped on the resist surface and was left standing for 60 seconds. Then, the substrate was rotated at 2000 rpm to remove the developing solution, and the rotation was maintained for 60 seconds to dry the substrate surface.
(7) The resist located within 5 mm of the portion where the resist had been removed in step (2) above was removed, and the post-development resist film thickness "B" (nm) was measured using the stylus profilometer.
(8) A reduction "C" in resist film thickness (C=A-B) was calculated by subtracting the value "B" from the value "A."

### (Standard Reduction in Film Thickness)

Each resist undergoes a reduction in film thickness specific to the individual resist, namely reduction "D" (nm) in film thickness, which varies depending on the storage duration after the resist film is formed (hereinafter referred to as a standard reduction in film thickness). The reduction "D" in film thickness, which is not affected by antistatic film, was measured in advance as follows:
(1) Forming resist film: on a 4-inch silicon wafer (substrate), a 0.4 µm-thick chemically amplified resist was spin coated at 2000 rpm/60 sec., and the resist was prebaked at 130°C for 90 seconds to remove the solvent.
(2) Measuring resist film thickness: part of the resist formed on the substrate was removed, and the initial resist film thickness "E" (nm) was measured from the substrate surface set as the base position by using a stylus profilometer.
(3) Baking: the substrate with laminated resist was layered was heated on a hot plate at 120°C for 20 minutes under ambient air conditions, and the substrate was left standing at room temperature (25°C) for 90 seconds under ambient air conditions.
(4) Developing: 20 mL of a developing solution made of a 2.38 mass% TMAH solution was dropped on the resist surface and was left standing for 60 seconds. Then, the substrate was rotated at 2000 rpm to remove the developing solution, and the rotation was maintained for 60 seconds to dry the substrate surface.
(5) The resist located within 5 mm of the portion where the resist had been removed in step (2) above was removed, and the post-development resist film thickness "F" (nm) was measured using the stylus profilometer.
(6) A standard reduction "D" in resist thickness (D=F-E) was calculated by subtracting the value "E" from the value "F."

### <Measuring Glass Transition Temperature>

Using 5 mg of powdered water-soluble polymer (b), DSC analysis was conducted under the conditions specified below to evaluate the glass transition temperature of a water-soluble polymer (b).
Measuring instrument: Thermo plus EVO DSC 8230 (made by Rigaku Corporation)
Ambient: nitrogen
Flow rate: 50 mL/min.
Programmed temperature rise: 150°C (10°C/min), 20°C (50°C/min), 150°C (10°C/min)
Reference: alumina

### <Measuring Surface Tension>

A surface tension of each of compositions 1∼8 was measured at 25°C using a "Full Automatic Surface Tensiometer CBVP-Z" (made by Kyowa Interface Science). The results are shown in Table 1.

### [Production Example 1]

### <Conductive Polymer (a-1)>

One mol of 3-aminoanisole-4-sulfonic acid was dissolved at 0°C in 300 mL of an acetonitrile solution (water/acetonitrile=3:7) containing tetrabutylammonium hydroxide at 4 mol/L to obtain a monomer solution. Separately, 1 mol of ammonium peroxodisulfate was dissolved in 1 L of acetonitrile solution (water/acetonitrile=3:7) to obtain an oxidant solution. Next, the oxidant solution was cooled at 5°C, into which the monomer solution was dropped. After the dropping was completed, the mixture was further stirred at 25°C for 12 hours to obtain a reaction mixture containing a conductive polymer. After that, the conductive polymer was filtrated from the reaction mixture using a centrifugal filtration unit. Then, the conductive polymer was extracted with methanol and dried. Accordingly, 185 grams of powdered conductive polymer (a-1) was obtained. The molecular weight (Mw) of the conductive polymer (a-1) was 10000.

### [Production Example 2]

### <Conductive Polymer (a-2)>

One mol of 3-aminoanisole-4-sulfonic acid was dissolved at 0°C in 300 mL of an acetonitrile solution (water/acetonitrile=3:7) containing 1,5-diazabicyclo[4.3.0]-5-nonene at 4 mol/L to obtain a monomer solution. Separately, 1 mol of ammonium peroxodisulfate was dissolved in 1 L of an acetonitrile solution (water/acetonitrile=3:7) to obtain an oxidant solution. Then, the oxidant solution was cooled at 5°C, and the monomer solution was dropped into it. After the dropping was completed, the mixture was further stirred at 25°C for 12 hours to obtain a reaction mixture containing a conductive polymer. After that, the conductive polymer was filtrated from the reaction mixture using a centrifugal filtration unit. Then, the conductive polymer was extracted with methanol and dried. Accordingly, 185 grams of powdered conductive polymer (a-2) was obtained. The molecular weight (Mw) of the conductive polymer (a-2) was 10000.

### [Production Example 3]

### <Water-soluble Polymer (b-1)>

Into 100 mL of isopropyl alcohol as a solvent, 55 grams of N-vinylpyrrolidone as a vinyl monomer, 1 gram of azobisisobutyronitrile as a polymerization initiator, and 0.16 grams of n-octadecyl mercaptan as a chain-transfer agent to introduce a terminal hydrophobic group were dissolved and stirred. Then, the reaction solution was dropped at a dropping rate of 1 mL/min. into the isopropyl alcohol, which was heated to 80°C in advance of dropping polymerization. Dropping polymerization was performed while the isopropyl alcohol was kept at 80°C. After the dropping was completed, the mixture was further aged at 80°C for 2 hours, and was left standing to cool. Then, the mixture was concentrated under reduced pressure. The resultant reaction mixture was dissolved again in a small amount of acetone. The acetone solution of the reaction mixture was dropped into an excessive amount of n-hexane, resulting in a white precipitate, which was then filtrated. The filtrated precipitate was extracted with n-hexane and dried. Accordingly, 45 grams of water-soluble polymer (b-1) was obtained [water-soluble polymer (b-1): weight average molecular weight of 4800, terminal hydrophobic group: alkylthio group having 18 carbon atoms, glass transition temperature of 109°C]

### [Production Example 4]

### <Water-soluble Polymer (b-2)>

Into 100 mL of isopropyl alcohol as a solvent, 55 grams of N-vinylpyrrolidone as a vinyl monomer, 0.07 grams of azobisisobutyronitrile as a polymerization initiator, and 0.01 grams of n-octadecyl mercaptan as a chain-transfer agent to introduce a terminal hydrophobic group were dissolved and stirred. Then, the reaction solution was dropped at a dropping rate of 1 mL/min. into the isopropyl alcohol, which was heated to 80°C in advance of dropping polymerization. Dropping polymerization was performed while the isopropyl alcohol was kept at 80°C. After the dropping was completed, the mixture was further aged at 80°C for 2 hours, and was left standing to cool. Then, the mixture was concentrated under reduced pressure. The resultant reaction mixture was dissolved again in a small amount of acetone. An acetone solution of the reaction mixture was dropped into an excessive amount of n-hexane, resulting in a white precipitate, which was then filtrated. The filtrated precipitate was extracted with n-hexane and dried. Accordingly, 45 grams of water-soluble polymer (b-2) was obtained [water-soluble polymer (b-2): weight average molecular weight of 18600, terminal hydrophobic group: alkylthio group having 18 carbon atoms, glass transition temperature of 126°C]

### [Production Example 5]

### <Water-soluble Polymer (b-3)>

Into 100 mL of isopropyl alcohol as a solvent, 55 grams of N-vinylpyrrolidone as a vinyl monomer, 1 gram of azobisisobutyronitrile as a polymerization initiator, and 0.16 grams of n-hexadecyl mercaptan as a chain-transfer agent to introduce a terminal hydrophobic group were dissolved and stirred. Then, the reaction solution was dropped at a dropping rate of 1 mL/min. into the isopropyl alcohol, which was heated to 80°C in advance of dropping polymerization. Dropping polymerization was performed while the isopropyl alcohol was kept at 80°C. After the dropping was completed, the mixture was further aged at 80°C for 2 hours, and was left standing to cool. Then, the mixture was concentrated under reduced pressure. The resultant reaction mixture was dissolved again in a small amount of acetone. The acetone solution of the reaction mixture was dropped into an excessive amount of n-hexane, resulting in a white precipitate, which was then filtrated. The filtrated precipitate was extracted with n-hexane and dried. Accordingly, 45 grams of water-soluble polymer (b-3) was obtained [water-soluble polymer (b-3): weight average molecular weight of 4700, terminal hydrophobic group: alkylthio group having 16 carbon atoms, glass transition temperature of 110°C]

### [Production Example 6]

### <Water-soluble Polymer (b-4)>

Into 100 mL of isopropyl alcohol as a solvent, 55 grams of N-vinylpyrrolidone as a vinyl monomer, 1 gram of azobisisobutyronitrile as a polymerization initiator, and 0.16 grams of n-dodecyl mercaptan as a chain-transfer agent to introduce a terminal hydrophobic group were dissolved and stirred. Then, the reaction solution was dropped at a dropping rate of 1 mL/min. into the isopropyl alcohol, which was heated to 80°C in advance of dropping polymerization. Dropping polymerization was performed while the isopropyl alcohol was kept at 80°C. After the dropping was completed, the mixture was further aged at 80°C for 2 hours, and was left standing to cool. Then, the mixture was concentrated under reduced pressure. The resultant reaction mixture was dissolved again in a small amount of acetone. The acetone solution of the reaction mixture was dropped into an excessive amount of n-hexane, resulting in a white precipitate, which was then filtrated. The filtrated precipitate was extracted with n-hexane and dried. Accordingly, 45 grams of water-soluble polymer (b-4) was obtained [water-soluble polymer (b-4): weight average molecular weight of 4400, terminal hydrophobic group: alkylthio group having 12 carbon atoms, glass transition temperature of 112°C]

### [Production Example 7]

### <Water-soluble Polymer (b-5)>

Into 100 mL of isopropyl alcohol as a solvent, 55 grams of N-vinylpyrrolidone as a vinyl monomer, 0.07 grams of azobisisobutyronitrile as a polymerization initiator, and 0.01 grams of n-dodecyl mercaptan as a chain-transfer agent to introduce a terminal hydrophobic group were dissolved and stirred. Then, the reaction solution was dropped at a dropping rate of 1 mL/min. into the isopropyl alcohol, which was heated to 80°C in advance of dropping polymerization. Dropping polymerization was performed while the isopropyl alcohol was kept at 80°C. After the dropping was completed, the mixture was further aged at 80°C for 2 hours, and was left standing to cool. Then, the mixture was concentrated under reduced pressure. The resultant reaction mixture was dissolved again in a small amount of acetone. The acetone solution of the reaction mixture was dropped into an excessive amount of n-hexane, resulting in a white precipitate, which was then filtrated. The filtrated precipitate was extracted with n-hexane and dried. Accordingly, 45 grams of water-soluble polymer (b-5) was obtained [water-soluble polymer (b-5): weight average molecular weight of 17800, terminal hydrophobic group: alkylthio group having 12 carbon atoms, glass transition temperature of 128°C]

Conductive polymers and water-soluble polymers obtained in Production Examples 1∼7 were used to prepare conductive compositions as shown in Table 1.

**Table 1**

| Conductive Composition | | 1 | 2 | 3 | 4 | 5 | 6 | 7 | 8 |
|---|---|---|---|---|---|---|---|---|---|
| Conductive Polymer (a) [part by mass] | a-1 | 0.13 | 0.13 | | 0.13 | | 0.13 | 0.13 | |
| | a-2 | | | 0.13 | | 0.13 | | | 0.13 |
| Water-soluble Polymer (b) [part by mass] | b-1 | 0.03 | | 0.03 | | | | | |
| | b-2 | | 0.03 | | | | | | |
| | b-3 | | | | 0.03 | 0.03 | | | |
| | b-4 | | | | | | 0.03 | | 0.03 |
| | b-5 | | | | | | | 0.03 | |
| Water [part by mass] | | 10 | 10 | 10 | 10 | 10 | 10 | 10 | 10 |
| Surface Tension [mN/m] | | 40 | 45 | 38 | 50 | 50 | 61 | 63 | 62 |

### (Examples 1∼5)

On each of conductive compositions 1∼5 shown in Table 1, conductivity, development speed, and reduction in film thickness were evaluated according to the evaluation methods respectively described above. The results are shown in Table 2.

### (Comparative Examples 1∼3)

On each of conductive compositions 6∼8 shown in Table 1, conductivity, development speed, and reduction in film thickness were evaluated according to the evaluation methods respectively described above. The results are shown in Table 2.

**Table 2**

| | Conductive Composition | Surface Resistance Value [Ω] | Development Speed | Reduction in Film Thickness [nm] |
|---|---|---|---|---|
| Example 1 | 1 | 9.0E+10 | ±0 | 0 |
| Example 2 | 2 | 9.0E+10 | ±0 | 1 |
| Example 3 | 3 | 3.0E+09 | ±0 | 0 |
| Example 4 | 4 | 9.0E+10 | ±0 | 1 |
| Example 5 | 5 | 3.0E+09 | ±0 | 1 |
| Comp. Example 1 | 6 | 9.0E+10 | + | 3 |
| Comp. Example 2 | 7 | 9.0E+10 | + | 2 |
| Comp. Example 3 | 8 | 3.0E+09 | ++ | 2 |

Compared with Comparative Examples 1∼3 respectively prepared by using water-soluble polymers (b-4, b-5) each containing a terminal hydrophobic group having 12 carbon atoms, Examples 1∼5 respectively prepared by using conductive polymers (a-1, a-2) and water-soluble polymers (b-1, b-2, b-3) each containing a terminal hydrophobic group having at least 13 carbon atoms showed that impact on a positive resist or negative resist was suppressed, and development speed and reduction in film thickness were less likely to be affected.

From the results above, when the conductive compositions related to the present invention each contain a water-soluble polymer with a terminal hydrophobic group having at least 13 carbon atoms, the compositions exhibit excellent coating properties and conductivity, and are capable of forming a film that is less likely to adversely affect a laminate coated on a substrate.

Examples of specific applications of the conductive composition and a conductor containing a film formed by coating the composition on a substrate according to the embodiments of the present invention are various antistatic agents, antistatic agents used during electron-beam lithography, capacitors, batteries, EMI shields, chemical sensors, display devices, non-linear materials, anticorrosive agents, adhesives, fibers, antistatic coatings, anticorrosion coatings, electrodeposition coatings, plating primers, electric anticorrosives, packaging materials, magnetic cards, magnetic tapes, magnetic disks, photographic films, printing materials, releasing films, heat sealing tapes, IC trays, IC carrier tapes, cover tapes, and batteries and the like.

Among those, the conductive composition related to the present invention is preferable when used as an antistatic agent, since the conductive composition is capable of forming film that is less likely to affect the substrate adversely.

### Industrial Applicability

Since the conductive compositions related to the present invention exhibit excellent coating properties and conductivity while the compositions coated on a substrate are less likely to negatively affect a laminate such as a resist coated on the substrate, the compositions are significantly useful when employed in industrial applications.

## Claims

1. A conductive composition, comprising:
a conductive material (A); and
a water-soluble polymer (b) containing a hydrophilic group and a terminal hydrophobic group having at least 13 carbon atoms, wherein
the conductive material (A) comprises a conductive polymer (a),
the hydrophilic group of the water-soluble polymer (b) comprises a nitrogen atom, and
the conductive polymer (a) comprises a sulfonic acid group or carboxyl acid group.

2. The conductive composition according to Claim 1, wherein the conductive material (A) comprises an ionic polymer.

3. The conductive composition according to Claim 1 or 2, wherein the hydrophilic group of the water-soluble polymer (b) is an amide group.

4. The conductive composition according to any of Claims 1∼3, wherein the terminal hydrophobic group of the water-soluble polymer (b) is at least a group selected from among alkyl groups, aralkyl groups and aryl groups.

5. The conductive composition according to Claim 4, wherein the terminal hydrophobic group of the water-soluble polymer (b) is at least a group selected from among alkylthio groups, aralkylthio groups and arylthio groups.

6. The conductive composition according to any of Claims 1∼5, wherein the water-soluble polymer (b) comprises a hydrophilic group and a terminal hydrophobic group having at least 16 carbon atoms.

7. The conductive composition according to any of Claims 1∼6, wherein the mass average molecular weight of the water-soluble polymer (b) is set at 1500 or greater.

8. The conductive composition according to any of Claims 1∼7, wherein the content of the water-soluble polymer (b) is set at 0.01∼50 mass% of the total mass of the conductive composition.

9. The conductive composition according to any of Claims 1∼8, wherein the conductive polymer (a) comprises a repeating unit represented by general formula (1) below. 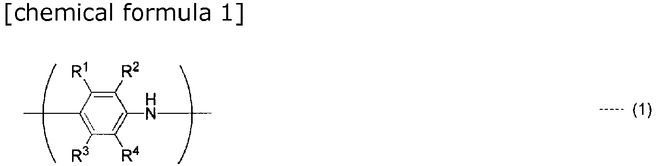 In formula (1), R¹∼R⁴ independently represent a hydrogen atom, straight- or branched-chain alkyl group having 1∼24 carbon atoms, straight- or branched-chain alkoxy group having 1∼24 carbon atoms, acidic group, hydroxyl group, nitro group, or halogen atom; at least one of R¹∼R⁴ is an acidic group or its salt; and the acidic group is a sulfonic acid group or carboxyl acid group.

10. The conductive composition according to any of Claims 1∼9, wherein the water-soluble polymer (b) is represented by general formula (6) below. 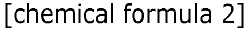 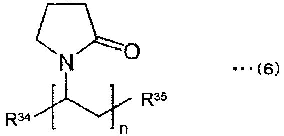 In formula (6), R³⁴ and R³⁵ independently represent hydrogen, hydroxyl group, carboxyl group, alkyl group-substituted carboxyl group, aralkylthio group-substituted carboxyl group, or arylthio group-substituted carboxyl group, alkylthio group, aralkylthio group or arylthio group; at least one of R³⁴ and R³⁵ is an alkylthio group, aralkylthio group or arylthio group; and "n" indicates an integer of 10∼100000.

11. A method for forming a conductor, comprising:
forming a film by coating the conductive composition according to any of Claims 1∼10 on the chemically amplified resist layer formed on at least one surface of a substrate.

12. The method for forming a conductor according to Claim 11, further comprising leaving the film at room temperature or applying heat to the film after the film is formed.

13. The method for forming a conductor according to Claim 12, wherein the temperature for applying heat is set at 40∼250°C.

14. A conductor, comprising:
a chemically amplified resist layer on at least one surface of a substrate; and
a layer formed on the chemically amplified resist layer by using the composition according to any of Claims 1∼10.

15. A mask blank, comprising:
a chemically amplified resist layer on at least one surface of a substrate; and
a layer formed on the chemically amplified resist layer by using the conductive composition according to any of Claims 1∼10.

16. A method for forming a resist pattern, comprising:
using the mask blank according to Claim 15.

17. The conductive composition according to any of Claims 1∼10, wherein the water-soluble polymer (b) is set to have a mass average molecular weight of 1500 or greater and a surface tension of 10∼60 mN/m.

18. A method for producing the water-soluble polymer (b) according to Claim 17, wherein a vinyl monomer having a hydrophilic group is polymerized in the presence of a polymerization initiator and a chain-transfer agent having at least 13 carbon atoms so as to produce a polymer having a hydrophilic group and a terminal hydrophobic group having at least 13 carbon atoms.

## Patentansprüche

1. Leitfähige Zusammensetzung, die umfasst:
ein leitfähiges Material (A); und
ein wasserlösliches Polymer (b), das eine hydrophile Gruppe und eine endständige hydrophobe Gruppe mit zumindest 13 Kohlenstoffatomen enthält, wobei
das leitfähige Material (A) ein leitfähiges Polymer (a) umfasst,
die hydrophile Gruppe des wasserlöslichen Polymers (b) ein Stickstoffatom umfasst, und
das leitfähige Polymer (a) eine Sulfonsäuregruppe oder eine Carboxylsäuregruppe umfasst.

2. Leitfähige Zusammensetzung nach Anspruch 1, wobei das leitfähige Material (A) ein ionisches Polymer umfasst.

3. Leitfähige Zusammensetzung nach Anspruch 1 oder 2, wobei die hydrophile Gruppe des wasserlöslichen Polymers (b) eine Amidgruppe ist.

4. Leitfähige Zusammensetzung nach einem der Ansprüche 1∼3, wobei die endständige hydrophobe Gruppe des wasserlöslichen Polymers (b) zumindest eine Gruppe ist, die aus Alkylgruppen, Aralkylgruppen und Arylgruppen ausgewählt ist.

5. Leitfähige Zusammensetzung nach Anspruch 4, wobei die endständige hydrophobe Gruppe des wasserlöslichen Polymers (b) zumindest eine Gruppe ist, die aus Alkylthiogruppen, Aralkylthiogruppen und Arylthiogruppen ausgewählt ist.

6. Leitfähige Zusammensetzung nach einem der Ansprüche 1∼5, wobei das wasserlösliche Polymer (b) eine hydrophile Gruppe und eine endständige hydrophobe Gruppe mit zumindest 16 Kohlenstoffatomen umfasst.

7. Leitfähige Zusammensetzung nach einem der Ansprüche 1∼6, wobei das massengemittelte Molekulargewicht des wasserlöslichen Polymers (b) auf 1500 oder mehr eingestellt ist.

8. Leitfähige Zusammensetzung nach einem der Ansprüche 1∼7, wobei der Gehalt des wasserlöslichen Polymers (b) auf 0,01∼50 Massen-% der Gesamtmasse der leitfähigen Zusammensetzung eingestellt ist.

9. Leitfähige Zusammensetzung nach einem der Ansprüche 1∼8, wobei das leitfähige Polymer (a) eine Wiederholungseinheit umfasst, die durch die folgende Formel (1) dargestellt ist. 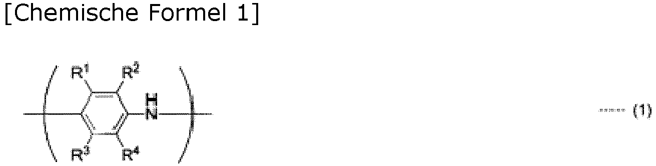 In der Formel (1) stellen R¹∼R⁴ unabhängig voneinander ein Wasserstoffatom, eine gerad- oder verzweigtkettige Alkylgruppe mit 1∼24 Kohlenstoffatomen, eine gerad- oder verzweigtkettige Alkoxygruppe mit 1∼24 Kohlenstoffatomen, eine Säuregruppe, eine Hydroxylgruppe, eine Nitrogruppe oder ein Halogenatom dar; zumindest eine der Gruppen R¹∼R⁴ ist eine Säuregruppe oder ihr Salz; und die Säuregruppe ist eine Sulfonsäuregruppe oder eine Carboxylsäuregruppe.

10. Leitfähige Zusammensetzung nach einem der Ansprüche 1∼9, wobei das wasserlösliche Polymer (b) durch die folgende allgemeine Formel (6) dargestellt ist. 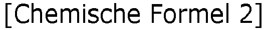 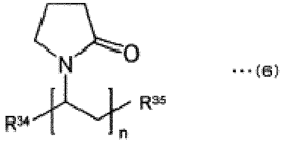 In der Formel (6) stellen R³⁴ und R³⁵ unabhängig voneinander Wasserstoff, eine Hydroxylgruppe, eine Carboxylgruppe, eine Alkylgruppen-substituierte Carboxylgruppe, eine Aralkylthiogruppen-substituierte Carboxylgruppe oder eine Arylthiogruppen-substituierte Carboxylgruppe, eine Alkylthiogruppe, eine Aralkylthiogruppe oder eine Arylthiogruppe dar; zumindest eines von R³⁴ und R³⁵ ist eine Alkylthiogruppe, eine Aralkylthiogruppe oder eine Arylthiogruppe; und "n" zeigt eine ganze Zahl von 10∼100000 an.

11. Verfahren zur Bildung eines Leiters, das umfasst:
Bilden eines Films durch Beschichten der leitfähigen Zusammensetzung nach einem der Ansprüche 1∼10 auf die chemisch verstärkte Resistschicht, die auf zumindest einer Oberfläche eines Substrats gebildet ist.

12. Verfahren zur Bildung eines Leiters nach Anspruch 11, das ferner das Belassen des Films bei Raumtemperatur oder das Aufbringen von Wärme auf den Film nach der Bildung des Films umfasst.

13. Verfahren zur Herstellung eines Leiters nach Anspruch 12, wobei die Temperatur zum Aufbringen von Wärme auf 40-250°C eingestellt wird.

14. Leiter, der umfasst:
eine chemisch verstärkte Resistschicht auf zumindest einer Oberfläche eines Substrats; und
eine Schicht, die auf der chemisch verstärkten Resistschicht unter Verwendung der Zusammensetzung nach einem der Ansprüche 1∼10 gebildet ist.

15. Maskenrohling, der umfasst:
eine chemisch verstärkte Resistschicht auf zumindest einer Oberfläche eines Substrats; und
eine Schicht, die auf der chemisch verstärkten Resistschicht unter Verwendung der leitfähigen Zusammensetzung nach einem der Ansprüche 1∼10 gebildet ist.

16. Verfahren zur Bildung eines Resistmusters, das umfasst:
Verwenden des Maskenrohlings nach Anspruch 15.

17. Leitfähige Zusammensetzung nach einem der Ansprüche 1∼10, wobei das wasserlösliche Polymer (b) so eingestellt ist, dass es ein massengemitteltes Molekulargewicht von 1500 oder mehr und eine Oberflächenspannung von 10∼60 mN/m aufweist.

18. Verfahren zur Herstellung des wasserlöslichen Polymers (b) nach Anspruch 17, wobei ein Vinylmonomer mit einer hydrophilen Gruppe in Gegenwart eines Polymerisationsinitiators und eines Kettenübertragungsmittels mit zumindest 13 Kohlenstoffatomen polymerisiert wird, um ein Polymer mit einer hydrophilen Gruppe und einer endständigen hydrophoben Gruppe mit zumindest 13 Kohlenstoffatomen herzustellen.

## Revendications

1. Composition conductrice comprenant :
un matériau conducteur (A) ; et
un polymère soluble dans l'eau (b) contenant un groupe hydrophile et un groupe hydrophobe terminal ayant au moins 13 atomes de carbone,
dans laquelle
le matériau conducteur (A) comprend un polymère conducteur (a),
le groupe hydrophile du polymère soluble dans l'eau (b) comprend un atome d'azote, et
le polymère conducteur (a) comprend un groupe acide sulfonique ou un groupe acide carboxylique.

2. Composition conductrice selon la revendication 1, dans laquelle le matériau conducteur (A) comprend un polymère ionique.

3. Composition conductrice selon la revendication 1 ou 2, dans laquelle le groupe hydrophile du polymère soluble dans l'eau (b) est un groupe amide.

4. Composition conductrice selon l'une quelconque des revendications 1 à 3, dans laquelle le groupe hydrophobe terminal du polymère soluble dans l'eau (b) est au moins un groupe choisi parmi les groupes alkyle, les groupes aralkyle et les groupes aryle.

5. Composition conductrice selon la revendication 4, dans laquelle le groupe hydrophobe terminal du polymère soluble dans l'eau (b) est au moins un groupe choisi parmi les groupes alkylthio, les groupes aralkylthio et les groupes arylthio.

6. Composition conductrice selon l'une quelconque des revendications 1 à 5, dans laquelle le polymère soluble dans l'eau (b) comprend un groupe hydrophile et un groupe hydrophobe terminal ayant au moins 16 atomes de carbone.

7. Composition conductrice selon l'une quelconque des revendications 1 à 6, dans laquelle la masse moléculaire moyenne en masse du polymère soluble dans l'eau (b) est établie à 1 500 ou plus.

8. Composition conductrice selon l'une quelconque des revendications 1 à 7, dans laquelle la teneur en le polymère soluble dans l'eau (b) est établie à 0,01 à 50 % en masse de la masse totale de la composition conductrice.

9. Composition conductrice selon l'une quelconque des revendications 1 à 8, dans laquelle le polymère conducteur (a) comprend un motif répétitif représenté par la formule générale (1) ci-dessous : 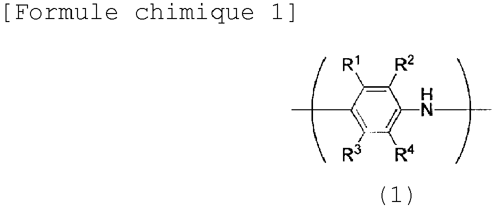 dans la formule (1), R¹ à R⁴ représentent indépendamment un atome d'hydrogène, un groupe alkyle à chaîne droite ou ramifiée ayant 1 à 24 atomes de carbone, un groupe alcoxy à chaîne droite ou ramifiée ayant 1 à 24 atomes de carbone, un groupe acide, un groupe hydroxyle, un groupe nitro, ou un atome d'halogène ; au moins l'un de R¹ à R⁴ est un groupe acide ou son sel ; et le groupe acide est un groupe acide sulfonique ou un groupe acide carboxylique.

10. Composition conductrice selon l'une quelconque des revendications 1 à 9, dans laquelle le polymère soluble dans l'eau (b) est représenté par la formule générale (6) ci-dessous 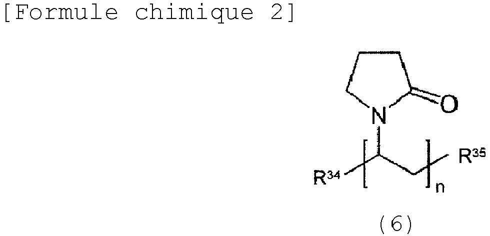 dans la formule (6), R³⁴ et R³⁵ représentent indépendamment l'hydrogène, un groupe hydroxyle, un groupe carboxyle, un groupe carboxyle substitué par un groupe alkyle, un groupe carboxyle substitué par un groupe aralkylthio, ou un groupe carboxyle substitué par un groupe arylthio, un groupe alkylthio, un groupe aralkylthio ou un groupe arylthio ; au moins l'un de R³⁴ et R³⁵ est un groupe alkylthio, un groupe aralkylthio ou un groupe arylthio ; et "n" indique un entier de 10 à 100 000.

11. Procédé pour former un conducteur, comprenant la formation d'un film par déposition sous forme de revêtement de la composition conductrice de l'une quelconque des revendications 1 à 10 sur la couche de réserve chimiquement amplifiée formée sur au moins une surface d'un substrat.

12. Procédé pour former un conducteur selon la revendication 11, comprenant en outre le fait de laisser le film à la température ambiante ou l'application de chaleur au film après la formation du film.

13. Procédé pour former un conducteur selon la revendication 12, dans lequel la température pour l'application de chaleur est établie à 40 à 250 °C.

14. Conducteur comprenant :
une couche de réserve chimiquement amplifiée sur au moins une surface d'un substrat ; et
une couche formée sur la couche de réserve chimiquement amplifiée par utilisation de la composition selon l'une quelconque des revendications 1 à 10.

15. Ebauche de masque comprenant :
une couche de réserve chimiquement amplifiée sur au moins une surface d'un substrat ; et
une couche formée sur la couche de réserve chimiquement amplifiée par utilisation de la composition conductrice selon l'une quelconque des revendications 1 à 10.

16. Procédé de formation d'un motif de réserve, comprenant l'utilisation de l'ébauche de masque selon la revendication 15.

17. Composition conductrice selon l'une quelconque des revendications 1 à 10, dans laquelle le polymère soluble dans l'eau (b) est établi de façon à avoir une masse moléculaire moyenne en masse de 1 500 ou plus et une tension de surface de 10 à 60 mN/m.

18. Procédé pour produire le polymère soluble dans l'eau (b) selon la revendication 17, dans lequel un monomère vinylique ayant un groupe hydrophile est polymérisé en présence d'un amorceur de polymérisation et d'un agent de transfert de chaîne ayant au moins 13 atomes de carbone de façon à produire un polymère ayant un groupe hydrophile et un groupe hydrophobe terminal ayant au moins 13 atomes de carbone.
